(19) **Europäisches Patentamt**
**European Patent Office**
**Office européen des brevets**

(11) **EP 3 516 442 B1**

(12) **FASCICULE DE BREVET EUROPEEN**

(45) Date de publication et mention de la délivrance du brevet:
**18.05.2022 Bulletin 2022/20**

(21) Numéro de dépôt: **17780494.5**

(22) Date de dépôt: **22.09.2017**

(51) Classification Internationale des Brevets (IPC):
**G02B 26/08** (2006.01)   **B81B 3/00** (2006.01)

(52) Classification Coopérative des Brevets (CPC):
**B81B 3/0097; F16K 99/0048; G02B 26/0825; H01L 41/0933; H01L 41/094;** B81B 2201/032; B81C 2201/019

(86) Numéro de dépôt international:
**PCT/FR2017/052547**

(87) Numéro de publication internationale:
**WO 2018/055302 (29.03.2018 Gazette 2018/13)**

(54) **DISPOSITIF A MEMBRANE SUSPENDUE PRESENTANT UNE AMPLITUDE DE DEPLACEMENT AUGMENTEE**

VORRICHTUNG MIT EINER HÄNGENDEN MEMBRAN MIT ERHÖHTER VERDRÄNGUNGSAMPLITUDE

DEVICE WITH A SUSPENDED MEMBRANE HAVING AN INCREASED AMPLITUDE OF DISPLACEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.09.2016 FR 1658959**

(43) Date de publication de la demande:
**31.07.2019 Bulletin 2019/31**

(73) Titulaire: **Commissariat à l'énergie atomique et aux énergies alternatives**
**75015 Paris (FR)**

(72) Inventeurs:
- **CASSET, Fabrice**
  **38570 Tencin (FR)**
- **PONCET, Pauline**
  **38610 Gières (FR)**

(74) Mandataire: **Brevalex**
**95, rue d'Amsterdam**
**75378 Paris Cedex 8 (FR)**

(56) Documents cités:
**EP-A1- 2 416 488     JP-A- 2003 262 920**
**US-A1- 2002 109 436     US-B1- 8 440 973**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Processed by Luminess, 75001 PARIS (FR)

## Description

La présente invention se rapporte à un dispositif à membrane suspendue présentant une amplitude de déplacement augmentée.

Les dispositifs à membrane suspendue en particulier dans le domaine de la microélectronique ont de nombreuses applications.

L'une de ses applications est la réalisation de laboratoires sur puce ou « lab-on-chip » pour le traitement de cellules biologiques, notamment pour réaliser de la délivrance intracellulaire. Pour cela les cellules adhèrent à la surface d'une membrane, celle-ci est déformée par la mise en œuvre d'un ou plusieurs actionneurs, ce qui provoque la déformation de l'enveloppe de la cellule et l'apparition de trous membranaires réversibles et qui permettent la délivrance de substances à la cellule.

Afin d'être efficace, l'amplitude de la déformation appliquées aux cellules pour faire apparaître des trous membranaires doit être relativement importante, ce qui requiert des actionneurs aptes à générer des déplacements importants.

Une autre application de ces dispositifs à membrane suspendue est la réalisation d'interfaces haptiques, par exemple de boutons haptiques. Un utilisateur passe son doigt sur la membrane, la membrane est alors déformée selon un motif haptique donné pour transmettre une information à l'utilisateur. Or pour avoir un bon ressenti haptique, on cherche à avoir une amplitude de déformation de la membrane importante.

Par ailleurs pour pouvoir avoir des déplacements importants, par exemple de l'ordre de plusieurs $\mu$m, il est souhaitable de mettre en œuvre des membranes en matériau polymère qui offrent une aptitude importante à la déformation.

Or les matériaux piézoélectriques mis en œuvre dans un actionneur piézoélectrique pouvant être déposés sur une membrane polymère présentent de faibles coefficients piézoélectriques. Le coefficient diélectrique relie la proportionnalité entre les charges et la contrainte. Des matériaux à faible coefficient diélectrique ne permettent pas la réalisation d'actionneurs générant de forts déplacements comme cela est décrit dans le document P. Poncet, F. Casset, A. Latour, F. Domingues Dos Santos, S. Pawlak, R. Gwoziecki, S. Fanget, "Design and realization of electroactive polymer actuators for transprent and flexible haptic feedback interfaces", Int. Conf. on Thermal, mechanical and multi-physics simulation and experiments in microelectronics and microsystems (Eurosime), 2016.

En effet les procédés pour réaliser des actionneurs mettant en œuvre des matériaux non organiques à forts coefficients piézoélectriques tels que le Titano-Zirconate de Plomb (PZT) ou l'AIN permettant de générer de forts déplacements requièrent des températures incompatibles avec l'utilisation d'une membrane en matériau polymère, par exemple une température de l'ordre de 700°C est requise pour le PZT et de 300°C pour l'AIN.

Dans le cas d'un système mettant en œuvre un ou des actionneurs thermiques, l'actionneur comporte un matériau solidaire de la membrane, lorsque l'actionneur est échauffé, le différentiel de dilatation thermique entre le matériau et le polymère de la membrane provoque une courbure de la membrane. Or le différentiel de dilatation thermique est trop faible pour former un actionneur efficace apte à déformer de manière importante la membrane.

Enfin, on cherche de manière supplémentaire à réaliser des dispositifs dans lesquels la membrane offre une certaine rigidité, par exemple afin d'appliquer une contrainte efficace aux cellules biologiques ou d'offrir un ressenti suffisant à l'utilisateur dans le cas d'une interface haptique.

Or une membrane polymère suspendue à un support n'offre généralement pas une rigidité suffisante.

Le document JP2003262920 décrit un dispositif d'affichage comportant un miroir munis d'éléments piézoélectrique sur sa face arrière pour provoquer la microvibration du miroir.

## EXPOSÉ DE L'INVENTION

Le but de la présente invention est alors d'offrir un dispositif à membrane polymère offrant une amplitude de déplacement augmentée.

Le but de la présente invention est atteint par un dispositif comportant une membrane en matériau polymère suspendue sur un support, au moins un module d'actionnement à effet bilame apte à appliquer une contrainte de déformation à la membrane lorsqu'il est activé, le module à effet bilame étant distinct de la membrane.

Grâce à l'invention, un ou des actionneurs à effet bilame, notamment des actionneurs piézoélectriques utilisant un matériau à coefficient piézoélectrique élevé peut ou peuvent être utilisés, puisque lors de la fabrication du dispositif, ils peuvent être réalisés de manière séparée de la membrane, aucun élément des actionneurs n'est réalisé sur la membrane. Le problème lié à la température ne se pose plus ou dans une moindre mesure.

En d'autres termes, l'effet bilame apparaît entre un élément, différent de la membrane, qui est solidaire de la structure et un matériau apte à se déformer sous l'effet d'un stimulus extérieur et non entre un tel matériau et la membrane. Ainsi on peut réaliser un module d'actionnement dans lequel le matériau n'a pas à être déposé sur la membrane.

Le module d'actionnement assure en outre une fonction de rigidification au moins partielle de la surface de contact.

Le stimulus extérieur est par exemple une différence de potentiels électriques dans le cas d'actionneurs piézoélectriques ou un apport de chaleur dans le cas d'actionneurs thermiques.

De préférence, le module d'actionnement comporte au moins une poutre de type encastrée libre.

Préférentiellement, le module d'actionnement comporte au moins deux actionneurs à effet bilame, l'un des actionneurs pouvant assurer une déformation importante de la membrane et l'autre actionneur déformant plus finement la membrane,
ce qui permet de mieux contrôler la déformée de la membrane. Cet exemple de réalisation permet de réaliser une membrane offrant une bonne rigidité.

De manière très avantageuse, le dispositif comporte également un actionneur électrostatique assurant le plaquage de la membrane sur le module d'actionnement, ce qui offre alors une rigidité supplémentaire à la membrane. L'actionneur électrostatique est formé en partie sur la membrane et en partie sur le module d'actionnement.

Il peut également être prévu de mettre en vibration la membrane, avantageusement en utilisant les actionneurs utilisés pour déformer la membrane.

La présente invention a alors pour objet un dispositif à membrane comportant un support, une membrane suspendue audit support et au moins un module d'actionnement disposé en regard d'une face de la membrane et distinct de ladite membrane, ledit module d'actionnement comportant au moins un premier actionneur comprenant au moins un premier matériau apte se dilater et/ou se contracter sous l'effet d'un stimulus extérieur solidaire d'un élément ancré au support et distinct de la membrane, de sorte que, lorsqu'un stimulus extérieur est appliqué au premier matériau, un effet bilame apparaît entre le premier matériau et l'élément, déformant l'élément en direction de la membrane et provoquant la déformation de la membrane fabriquée au moins en partie en un matériau polymère. Le dispositif comporte également au moins un actionneur électrostatique apte à plaquer au moins une partie de la membrane sur au moins une partie du module d'actionnement.

Le dispositif peut comporter plusieurs éléments ancrés au support.

Dans un exemple de réalisation, le ou les éléments comportent une poutre encastrée-libre.

Par exemple, les poutres encastrées-libres sont disposées radialement et chaque poutre comporte une extrémité libre, les extrémités libres des poutres étant situées au niveau d'une partie centrale de la membrane.

Dans un exemple avantageux, le module d'actionnement comporte en outre, au moins un deuxième actionneur comprenant un deuxième matériau apte se dilater et/ou se contracter sous l'effet d'un stimulus extérieur, ledit deuxième actionneur étant solidaire dudit élément.

De préférence, ledit deuxième matériau est disposé par rapport au premier matériau de sorte à être apte à appliquer audit élément une déformation de courbure opposée à celle appliquée par le premier matériau.

L'actionneur électrostatique peut comporter au moins une électrode portée par la membrane et au moins une électrode solidaire dudit élément. L'électrode solidaire de l'élément est avantageusement au moins l'une des électrodes du premier et/ou du deuxième actionneur

Le premier et/ou le deuxième matériau peut ou peuvent être un matériau piézoélectrique ou ferroélectrique, le premier et/ou le deuxième actionneur peuvent comporter des électrodes pour appliquer une différence de potentiel électrique au premier matériau et/ou au deuxième matériau.

Le premier matériau et/ou le deuxième matériau sont avantageusement choisis parmi l'AlN, le PZT, le ZNO, le LNO.

Dans un exemple de réalisation, le premier actionneur et/ou le deuxième actionneur est ou sont des actionneurs thermiques.

Selon une caractéristique additionnelle, le dispositif à membrane peut comporter des moyens pour mettre en vibration la membrane. Les moyens pour mettre en vibration la membrane comprennent avantageusement le premier et/ou le deuxième actionneur.

Dans un exemple avantageux, le matériau polymère de la membrane est un polymère transparent.

La présente invention a également pour objet un dispositif de traitement de cellules biologique comportant au moins un dispositif à membrane selon l'invention.

La présente invention a également pour objet une interface haptique comportant au moins un dispositif à membrane selon l'invention.

La présente invention a également pour objet un procédé de réalisation d'un dispositif à membrane selon l'invention, comportant les étapes :

- réalisation d'un module d'actionnement,
- réalisation d'une membrane au moins en partie en matériau polymère,
- réalisation d'un actionneur électrostatique configuré pour plaquer au moins une partie de la membrane sur au moins une partie du module d'actionnement,
- assemblage du module d'actionnement et de la membrane de sorte que l'activation du module d'actionnement déforme la membrane.

**BRÈVE DESCRIPTION DES DESSINS**

La présente invention sera mieux comprise sur la base de la description qui va suivre et des dessins en annexe sur lesquels:

- la figure 1 est une vue de dessus d'un exemple de réalisation d'un dispositif à membrane selon l'invention, la membrane étant omise,
- la figure 2 est une vue en coupe partielle du dispositif de la figure 1,
- la figure 3A est une vue de dessus d'une variante de réalisation du dispositif selon l'invention,
- la figure 3B est une vue de dessus d'une autre variante de réalisation du dispositif selon l'invention,
- les figures 4A et 4B sont des vues en coupe du dispositif de la figure 2 dans deux états d'actionnement,

- la figure 5 est une vue en coupe d'un exemple de système microfluidique mettant en œuvre le dispositif selon l'invention,
- la figure 6 une vue en coupe d'un exemple de dispositif haptique mettant en œuvre le dispositif selon l'invention,
- les figures 7A à 7S sont des représentations schématiques de différentes étapes d'un exemple de procédé de réalisation du dispositif selon l'invention.

## EXPOSÉ DÉTAILLÉ DE MODES DE RÉALISATION PARTICULIERS

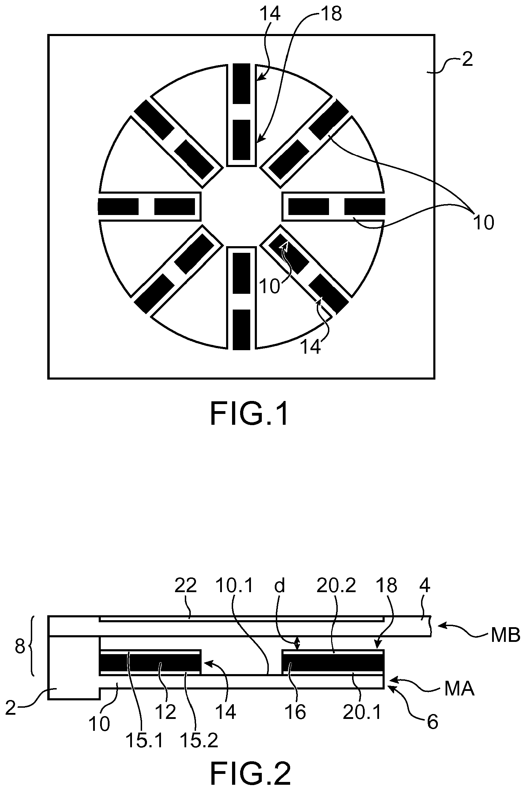

Sur les figures 1 et 2, on peut voir un exemple de réalisation d'un dispositif à membrane selon l'invention.

Le dispositif comporte un module d'actionnement désigné MA et un module MB comportant une membrane 4; les modules MA et MB sont réalisés séparément et assemblés par la suite.

Le dispositif comporte une membrane 4 en matériau polymère, un support 2 sur lequel la membrane 4 est suspendue, des moyens 6 pour déformer la membrane 4 et avantageusement des moyens 8 pour plaquer la membrane sur les moyens 6. Le module MA comporte les moyens 6 pour déformer la membrane 4 et une partie des moyens 8 pour plaquer la membrane sur les moyens 6. La membrane est disposée sur le module MA de sorte à être déformée lorsque les moyens 6 sont activés.

Dans l'exemple représenté la membrane 4 est circulaire mais une membrane de toute autre forme, par exemple ovale ou rectangulaire, ou même une poutre de type encastrée libre ou bi-encastrée ne sort pas du cadre de la présente invention.

La membrane 4 est réalisée au moins en partie en un matériau polymère offrant une aptitude à être déformée élastiquement avec une amplitude importante. L'aptitude à se déformer se traduit par un faible module d'Young, de l'ordre de quelques GPa, typiquement de 2 GPa à 6GPa. A titre de comparaison, le silicium présente un module d'Young de l'ordre de 160GPa.

La membrane est par exemple en poly(naphtalate d'éthylène) (PEN) ou en PolyCarbonate (PC) et peut comporter une ou plusieurs couches de polymère. Son épaisseur est par exemple comprise entre quelques $\mu$m et plusieurs centaines de $\mu$m.

La membrane pourrait également comporter sur ou sous le matériau polymère, des matériaux non polymères permettant par exemple une fonctionnalisation de la membrane, par exemple des matériaux de protections aux UV et/ou rayures et/ou aux produits cosmétiques.

De manière très avantageuse, le polymère est transparent ou partiellement transparent ce qui permet par exemple dans le cas d'un dispositif de traitement de cellules biologiques de caractériser par transparence les cellules. Dans le cas d'une interface haptique, la mise en œuvre d'une membrane transparente peut permettre de mettre en œuvre des moyens visuels sous la membrane qui pourraient être activés suivant l'action du doigt sur la membrane et être vus par l'utilisateur. Par exemple, il pourrait s'agir d'un pictogramme correspondant à l'action du bouton haptique que l'on va toucher.

Les moyens pour déformer la membrane comportent au moins une poutre 10 solidaire du support et au moins un premier matériau 12 apte à se déformer sous l'effet d'un stimulus extérieur de sorte à générer un effet bilame déformant la poutre et lui appliquant une déformation hors-plan. La poutre et le premier matériau forme un premier actionneur à effet bilame 14.

Dans l'exemple représenté et de manière avantageuse, plusieurs poutres 10 sont mises en œuvre. Les poutres sont avantageusement de type encastré-libre. En outre de manière avantageuse, les poutres sont réparties radialement et régulièrement sous la membrane 4 de sorte à pouvoir lui appliquer une déformation uniforme.

Le premier matériau est avantageusement un matériau piézoélectrique, par exemple de l'AlN, le LNO ou le ZnO présentant un coefficient piézoélectrique important. Dans ce cas le stimulus est une différence de potentiel électrique. Des électrodes 15.1 et 15.2 sont disposées de part et d'autres du matériau piézoélectrique 12. En appliquant une différence de potentiel entre les électrodes 15.1 et 15.2, le matériau 12 change de dimension ce qui, du fait du couplage avec la poutre 10, provoque une courbure de la poutre. La disposition de l'actionneur permet d'orienter la courbure de la poutre.

Suivant que la différence de potentiel appliquée aux électrodes 15.1, 15.2 est positive ou négative, le matériau va se dilater ou se contracter.

En variante, le premier actionneur pourrait comporter un matériau se déformant sous l'effet de la chaleur, le matériau présentant un coefficient de dilatation très différent de celui de la poutre, de sorte à présenter un différentiel de dilatation thermique important entre la poutre et le matériau et donc offrir une déformation importante. Le stimulus est alors un apport de chaleur.

Dans l'exemple représenté, le premier matériau 12 est disposé du côté de l'extrémité encastrée de la poutre 10 et sur une face 10.1 de la poutre 10 en regard de la membrane.

De manière très avantageuse, les moyens de déformation 6 comportent un deuxième actionneur 18 à effet bilame permettant de contrôler la déformée de la poutre et donc celle de la membrane.

Le deuxième actionneur 18 comporte un deuxième matériau 16 apte à être déformé sous l'action d'un stimulus extérieur et disposé du côté de l'extrémité libre de la poutre 10. Comme pour le premier matériau 12, le deuxième matériau 16 est avantageusement un matériau piézoélectrique, mais il pourrait s'agir d'un matériau sensible à la chaleur. En outre, les premier et deuxième actionneurs pourraient être de types différents.

Le deuxième actionneur 18 comporte également deux électrodes 20.1, 20.2 de part et d'autre du matériau piézoélectrique 16.

Dans l'exemple représenté, les deux actionneurs 14 et 18 sont disposés sur une face de la poutre 10 en regard d'une face de la membrane 4. Il peut être envisagé que les actionneurs soient disposés sur l'autre face de la poutre ou encore que les deux actionneurs soient disposés chacun sur une face différente de la poutre. Le signe des différences de potentiel appliquées à chacun des actionneurs est alors choisi en fonction de l'emplacement des actionneurs.

On pourrait envisager de remplacer les matériaux piézoélectriques par des matériaux ferroélectriques tels que le PZT, ces matériaux ont pour propriété soit de se contracter soit de se dilater sous l'effet d'une différence de potentiel quel que soit le signe de la différence de potentiel électrique On prévoit alors de disposer un premier matériau sur une face de la poutre dans une première zone et un deuxième matériau sur la face opposée de la poutre dans une deuxième zone, l'activation des premier et deuxième actionneurs provoquant des déformations de la première zone et de la deuxième zone selon des courbures opposées.

En outre, de manière avantageuse, les moyens 8 pour plaquer la membrane 4 sur le module d'actionnement MA comportent un actionneur électrostatique apte à assurer le plaquage de la membrane 4 sur le module d'actionnement MA.

Pour cela, la membrane comporte au moins une électrode 22 sur sa face 4.2 opposée à celle 4.1 contre laquelle la poutre est destinée à agir. Dans l'exemple représenté et de manière très avantageuse, l'actionneur électrostatique utilise les électrodes 15.1 et 20.1 des premier 14 et deuxième 18 actionneurs. De manière avantageuse, l'électrode 22 s'étend de sorte que sa projection sur la poutre 10 recouvre les électrodes 15.1 et 20.1. Ainsi l'électrode 20 forme avec l'électrode 15.1 du premier actionneur à effet bilame 14 un actionneur électrostatique, et forme avec l'électrode 20.1 du deuxième actionneur à effet bilame 18 un deuxième actionneur électrostatique. L'application d'une différence de potentiels entre les électrodes 22 et 15.1 et entre les électrodes 22 et 20.1 a pour effet de générer des forces électrostatiques qui vont plaquer la membrane sur les électrodes 15.1 et 20.1.

En variante, l'électrode 22 pourrait s'étendre de sorte à ne former un actionneur électrostatique qu'avec l'une des électrodes 15.1 ou 20.1 ou avec une partie seulement de l'une et l'autre des électrodes 15.1, 20.1.

En variante encore, on pourrait envisager une ou des électrodes 20 solidaires de la poutre qui soient distinctes de celles des actionneurs 14 et 18.

Dans l'exemple représenté, les moyens de déformation de la membrane 4 sont séparés d'une certaine distance d de la face 4.1 de la membrane à l'état repos.

De préférence la distance d est maîtrisée pour pouvoir contrôler précisément la déformation de la membrane.

En variante, les moyens de déformation 6 pourraient être en permanence en contact avec la face 4.1 de la membrane.

Il peut être prévu que la poutre 10 porte plus de deux actionneurs à effet bilame, ce qui permet de contrôler encore davantage la forme de la poutre. Par exemple, il pourrait être prévu de mettre en œuvre plusieurs actionneurs à la suite, en ajustant les tensions et les signes des tensions pour imposer la forme voulue à la membrane.

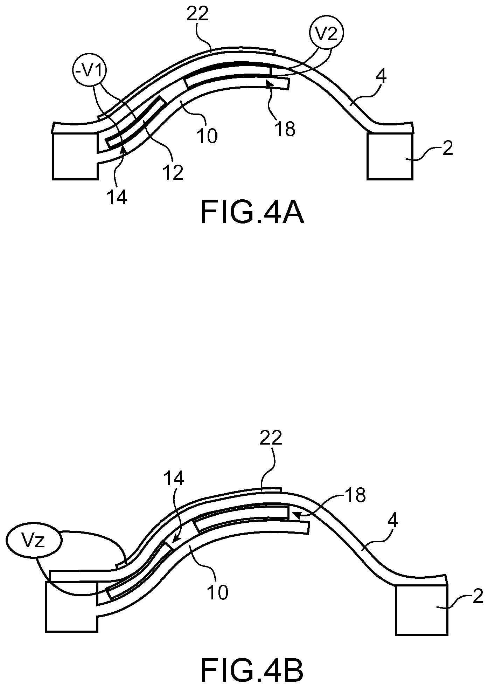

Le fonctionnement du dispositif va maintenant être décrit à l'aide des figures 4A et 4B. Seule une poutre est représentée.

Une différence de potentiel -V1 est appliquée entre les électrodes 15.1 et 15.2 du premier actionneur 14, le premier matériau 12 se contracte ce qui fait apparaître un effet bilame entre le premier matériau et la poutre 10 qui se courbe en direction de la membrane 4, et déforme celle-ci (figure 4A).

Une différence de potentiel +V2 de signe opposé à celle appliquée aux électrodes 15.1, 15.2, est appliquée entre les électrodes 20.1 et 20.1 de l'actionneur 18, le matériau 16 se dilate, un effet bilame apparaît entre le matériau 16 et la poutre 10, la zone de la poutre portant le matériau 16 se courbe selon une courbure opposée à celle provoquée par le premier actionneur 14.

La membrane 4 est alors avantageusement déformée selon un profil bombé (figure 4B). La membrane 4 présente alors une déflexion augmentée.

Il sera compris que les premier 14 et deuxième 18 actionneurs pourraient être activés simultanément.

Le deuxième actionneur 18 permet avantageusement de mieux contrôler la déformée de la membrane, et donc de mieux contrôler la contrainte appliquée par exemple à une cellule biologique pour la transfecter.

Lors d'une étape suivante, une différence de potentiel désignée Vz est appliquée entre les électrodes 15.1 et 20.1 et l'électrode 22 portée par la membrane 4, formant contre-électrode. Sous l'action de cette différence de potentiel, une force électrostatique apparait entre la membrane 4 et la poutre 10. Cette force est d'autant plus forte que l'entrefer est faible. La membrane vient en contact avec la poutre 10 au niveau des électrodes, il va en résulter un phénomène de plaquage de la membrane 4 sur la poutre 10, ce phénomène est appelé « zipping » et a été décrit dans le document Casset et al. « Zipping variable capacitor development », Mechatronics 2004.

Le plaquage de la membrane 4 sur la poutre 10 a pour effet de rigidifier la membrane 4. L'application d'une contrainte sur une cellule est alors mieux maîtrisée. Dans le cas d'une interface haptique, la sensation ressentie par l'utilisateur est améliorée.

Dans le cas particulier du traitement de cellules biologiques, la membrane fait partie d'un dispositif de traitement et forme un support de traitement sur lequel des cellules à traiter adhèrent. Le fonctionnement d'un dispositif de traitement selon l'invention va maintenant être décrit.

Le cas d'une seule cellule va être décrit, mais il sera compris qu'en général plusieurs cellules peuvent être traitées simultanément par le même dispositif en fonction de la taille du support de traitement.

Lors d'une première étape, la cellule que l'on veut traiter, i.e. à qui une délivrance cellulaire est à appliquer, est introduite dans le dispositif

La cellule est en général en suspension dans un milieu liquide. On utilise par exemple une pipette qui peut dispenser un volume de liquide et la quantité de cellule souhaités. En variante, un circuit microfluidique peut être connecté au dispositif.

Lors d'une deuxième étape, la cellule adhère au support de traitement. Pour cela une phase de sédimentation a lieu lors de laquelle la cellule va venir se déposer par gravité sur le support de traitement. La cellule s'accroche alors à la membrane et adhère. La durée de cette étape peut être de l'ordre de plusieurs dizaines de minutes. Plus cette étape est longue, plus l'intensité de la force d'adhésion est grande. Le contrôle de la durée de cette étape permet donc de contrôler la force d'adhésion de la cellule sur la membrane.

De manière avantageuse, la surface du support de traitement peut comporter des zones facilitant l'adhésion des cellules ou au contraire la rendant plus difficile. Dans ce cas la cellule adhère dans une zone où l'adhésion est favorisée ou au moins non détériorée.

En variante, il peut être envisagé d'utiliser un ou des pochoirs au-dessus de la surface du support, le ou les pochoirs étant réalisé(s) en un matériau qui ne favorise pas l'adhésion cellulaire et comporte(nt) des orifices aux endroits où l'on souhaite que les cellules se déposent. Le pochoir ou les pochoirs est ou sont ensuite retiré(s) à la fin de l'étape de sédimentation.

Lors d'une étape suivante, le milieu contenant les éléments à introduire dans la cellule est injecté dans le dispositif. Ce milieu est par exemple un milieu de culture contenant les macromolécules à introduire dans la cellule. Ce milieu peut être injecté au moyen d'une pipette ou d'un circuit fluidique, qui peut être le même que celui transportant le milieu contenant les cellules. Avantageusement, le milieu contenant les éléments à introduire dans la cellule sera injecté dans le dispositif de traitement préalablement à l'ouverture des pores.

Lors d'une étape suivante, on applique une déformation à la cellule. Pour cela on active l'actionneur ou les actionneurs en appliquant une différence de potentiel continue aux bornes des électrodes de l'actionneur ou les actionneurs. L'actionneur ou les actionneurs engendrent la déformation voulue du support, appliquant une déformation à la cellule qui a adhéré sur le support. Cette déformation provoque l'apparition d'au moins un pore transitoire. La durée d'application de la contrainte à la cellule est de l'ordre de quelques secondes.

Le choix de la différence de potentiel à appliquer à l'actionneur ou aux actionneurs est fait par l'opérateur au moyen par exemple d'abaques donnant la déflexion du support de traitement en fonction de la différence de potentiel appliquée pour réaliser un ou des pores transitoires dans des types donnés de cellules qui auront été réalisés lors de la fabrication du dispositif.

Lors d'une étape suivante, le ou les actionneurs sont désactivés en annulant la tension continue appliquée aux électrodes de l'actionneur, le support de traitement reprend sa position au repos et ramenant la cellule adhérente à un état non contraint, la membrane de la cellule comporte au moins un pore.

Tant que le ou les pores sont ouverts, les éléments à introduire contenus dans le milieu liquide pénètrent dans les cellules par le ou les pores.

Lors d'une étape suivante, aucune contrainte n'est appliquée à la cellule pour permettre la fermeture du ou des pores. Cette étape peut durer quelques minutes.

A la fin de l'étape de fermeture des pores, la cellule traitée est récupérée. La cellule peut subir plusieurs traitements pour se voir délivrer différents types d'éléments.

Le dispositif permet également d'appliquer très facilement une vibration à la membrane. En effet, la membrane et la poutre piézoélectrique étant rendues solidaires grâce aux forces électrostatiques, l'application d'une tension alternative en plus de la tension continue V1 sur l'actionneur piézoélectrique met celui-ci en vibration, mettant de fait la poutre et la membrane en vibration.

Ces vibrations peuvent par exemple être générées pour décoller ou trier des cellules biologiques sans endommager la cellule.

En outre en utilisant une membrane transparente, il est aisé de caractériser le taux de décollement des cellules de la membrane par la face arrière, en utilisant un microscope inversé qui est présent classiquement en laboratoire.

L'application de vibrations à la membrane est également intéressante dans le cas d'une interface haptique, en effet l'application de vibrations est un motif haptique très courant pour envoyer un signal vibrotactile à l'utilisateur.

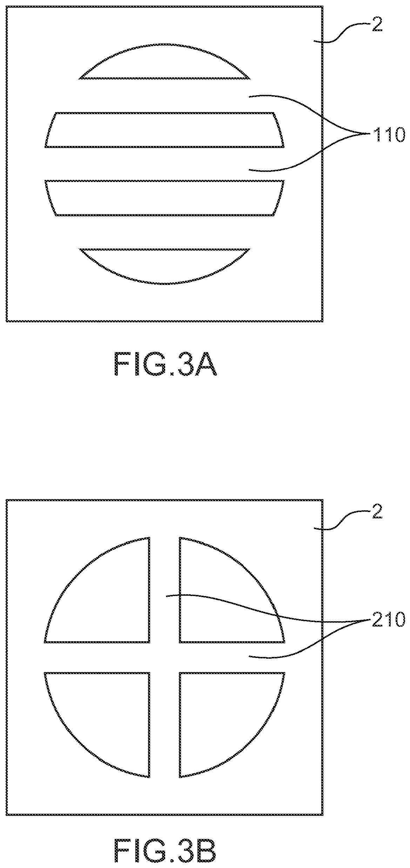

Sur les figures 3A, on peut voir des variantes de réalisation du dispositif selon l'invention comportant à la place de poutres encastrées-libres des poutres bi-encastrées.

Sur la figure 3A, les poutres 110 sont parallèles les unes aux autres.

Sur la figure 3B, les poutres 210 se croisent et sont d'un seul tenant pour former une croix.

D'autres configurations sont envisageables, comme par exemple la mise en œuvre à la fois d'une ou de plusieurs poutres bi-encastrées et d'une ou plusieurs poutre encastrées-libres. En variante, on peut mettre en œuvre une plaque.

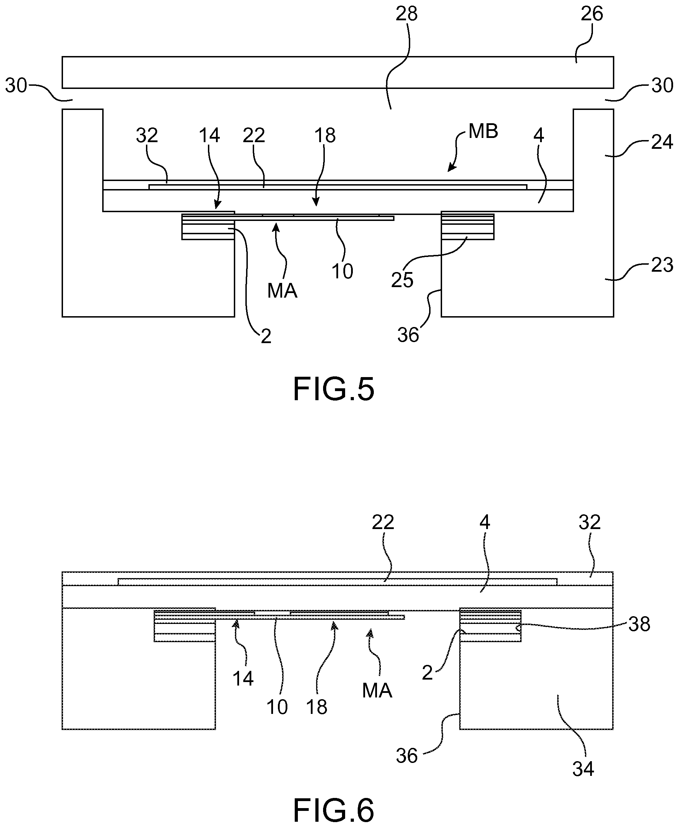

Sur la figure 5, on peut voir un exemple d'un système microfluidique S mettant en œuvre le dispositif à membrane selon l'invention et adapté par exemple au traitement de cellules biologiques.

Le système S comporte un boîtier 23 et un capot 26. Le boîtier 23 comporte un fond muni d'une ouverture 25. L'ouverture 25 est bordée d'un évidement 27 recevant le module d'actionnement MA; la membrane 4 est disposée sur le fond du boîtier 23 de sorte que la membrane soit suspendue au-dessus de l'ouverture 25. Le boîtier 23 comporte des parois latérales 24 délimitant avec le capot 26 une cavité fluidique 28. Un ou des orifices 30 dans les parois latérales permettent l'alimentation et l'évacuation d'une solution contenant les cellules biologiques à traiter.

De préférence le capot 26 est transparent. Dans cette application, la membrane 4 et en particulier l'électrode 22 est recouverte d'une couche 32, par exemple en polymère, de préférence pour isoler l'électrode du fluide qui va circuler dans la cavité et venir au contact de la membrane.

Sur la figure 6, on peut voir un exemple de réalisation d'un bouton haptique. Le bouton comporte un support 34 muni d'une ouverture 36. L'ouverture 36 est bordée d'un évidement 38 recevant le module d'actionnement MA ; la membrane 4 est disposée sur le module MA et sur le support de sorte que la membrane 4 soit suspendue au-dessus de l'ouverture 36. L'utilisateur peut par exemple passer son doigt sur la membrane et ressentir les motifs haptiques enregistrés.

Le support est par exemple en polycarbonate injecté ou en plexiglas. Par exemple lorsque le bouton haptique est disposé sur le tableau de bord d'une automobile ou dans un équipement électronique ou électroménager, le support peut être réalisé par injection ou impression 3D.

Comme pour le système microfluidique, la membrane 4 et en particulier l'électrode 22 est avantageusement recouverte d'une couche 32, par exemple en polymère, de préférence pour isoler l'électrode du fluide qui va circuler dans la cavité et venir au contact de la membrane.

A titre de comparaison, la déflexion obtenue grâce à un dispositif selon l'invention et celle obtenue par un dispositif dans lequel l'actionneur piézoélectrique est déposé directement sur la membrane vont être comparées.

Nous considérons un dispositif D selon la figure 2 comportant une membrane de 10 mm de diamètre. Pour plus de simplicité, le calcul sera fait en ne prenant en compte qu'une seule poutre.

La poutre a une longueur de 4,8 mm, une largeur de 1 mm et une épaisseur de 8 $\mu$m. Elle est constituée de silicium. Les actionneurs 14 et 18 sont en AIN et ont une épaisseur de 2 $\mu$m. Les actionneurs mesurent 1,5 mm de long et 0,8 mm de largeur.

En appliquant une tension d'actionnement de 200 V, la déflection observée est de 1,092 $\mu$m. En utilisant des actionneurs en PZT qui a un coefficient piézoélectrique multiplié par environ 100 par rapport à celui de l'AIN, la déflexion serait également multipliée par environ 100. Le coefficient piézoélectrique du PZT est de l'ordre de -170pm/V et celui de l'AIN est de l'ordre de -1.6pm/V.

La déflection d'une membrane dans le cas où l'actionneur piézoélectrique est déposé directement sur le polymère va maintenant être calculée. Comme cela a été expliqué ci-dessus, le matériau piézoélectrique pouvant être déposé sur un polymère présente un faible coefficient piézoélectrique, par exemple de l'ordre de 3pm/V). La membrane est en polycarbonate d'une épaisseur de 175 $\mu$m et comporte une couche de polymère électroactif PVDF-TrFE de 2,4 $\mu$m. Le diamètre de la membrane est de 10 mm, et l'actionneur a pour diamètre 60% de celui de la membrane soit 6 mm. La membrane est encastrée sur toute sa périphérie.

Une tension de 200V est appliquée aux bornes du matériau piézoélectrique, un déplacement de 337 nm est observé.

On constate qu'en utilisant des actionneurs en AIN dans un dispositif selon l'invention, le déplacement peut être multiplié au moins par 3 et par au moins 300 en utilisant des actionneurs en PZT.

A titre de comparaison également, les forces générées par un dispositif selon l'invention et une membrane sur laquelle est déposé l'actionneur vont être estimées.

Selon les équations suivantes, la force restituée (F) peut être calculée.

$$F = k \cdot x \qquad with \ k = f_0^{\ 2} \cdot (2\pi)^2 \cdot m$$

Avec k la rigidité du système considéré, $f_0$ sa fréquence de résonance et m la masse de la membrane.

Pour une membrane en matériau polymère sur laquelle est déposé l'actionneur, la force restituée lorsqu'elle est actionnée à 200V est de 4,81 mN.

Dans le cas d'un dispositif selon l'invention comportant 8 poutres telles que représentées sur la figure 1, le retour de force estimé est de 80,2 mN, soit plus de 16 fois plus élevé.

L'utilisation du dispositif selon l'invention pour réaliser un bouton à retour de force est particulièrement avantageuse puisqu'il permet d'obtenir des forces offrant un ressenti satisfaisant.

Un exemple de procédé de réalisation d'un dispositif à membrane selon l'invention va maintenant être décrit. Il s'agit avantageusement d'un procédé mettant en œuvre des techniques de la microélectronique, ce qui permet de réaliser un dispositif adapté à la taille de cellules. D'autres procédés pourraient être envisagés.

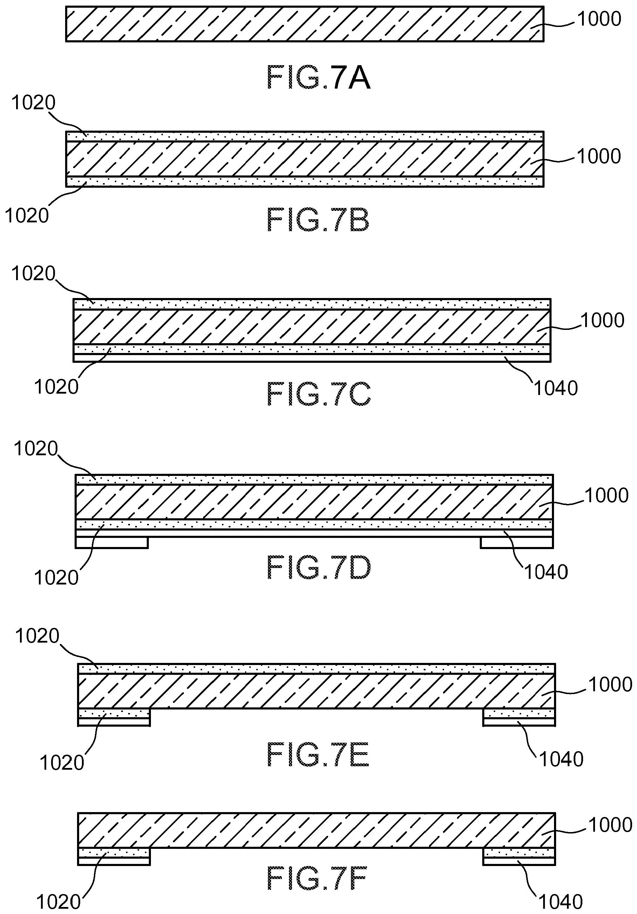

Les étapes sont représentées schématiquement sur les figures 7A à 7S.

Par exemple, on utilise un substrat en silicium 1000 représenté sur la figure 7A, ayant par exemple une épaisseur de 725 $\mu$m et un diamètre de 200mm de diamètre. Un substrat en verre par exemple peut être envisagé.

Lors d'une première étape, on effectue une oxydation thermique du substrat de sorte à former une couche d'oxyde 1020 sur toutes les surfaces du substrat d'une épaisseur de 2 μm par exemple. L'élément ainsi obtenu est représenté sur la figure 7B.

Ensuite, on réalise un masque dur d'oxyde 1040 sur la face arrière du substrat. Ce masque a par exemple une épaisseur de 7 μm. Le masque est réalisé en retournant le substrat; en fonction de la composition de dépôt choisie; il est possible de ne déposer le masque que sur cette face. Il peut s'agir par exemple d'un dépôt de type PVD (Physical Vapor Deposition en terminologie anglosaxonne). L'élément ainsi obtenu est représenté sur la figure 7C.

On effectue ensuite une lithographie sur le masque dur. L'élément ainsi obtenu est représenté sur la figure 7D.

Lors d'une étape suivante, on grave, par exemple par gravure ionique réactive (RIE : Reactive-Ion Etching en terminologie anglo-saxonne), le masque dur et la couche d'oxyde 1020 en face arrière de sorte à atteindre la face arrière du substrat 1000. L'élément ainsi obtenu est représenté sur la figure 7E.

Lors d'une étape suivante, on retire la couche d'oxyde sur la face avant, par exemple par désoxydation ou gravure chimique. L'élément ainsi obtenu est représenté sur la figure 7F.

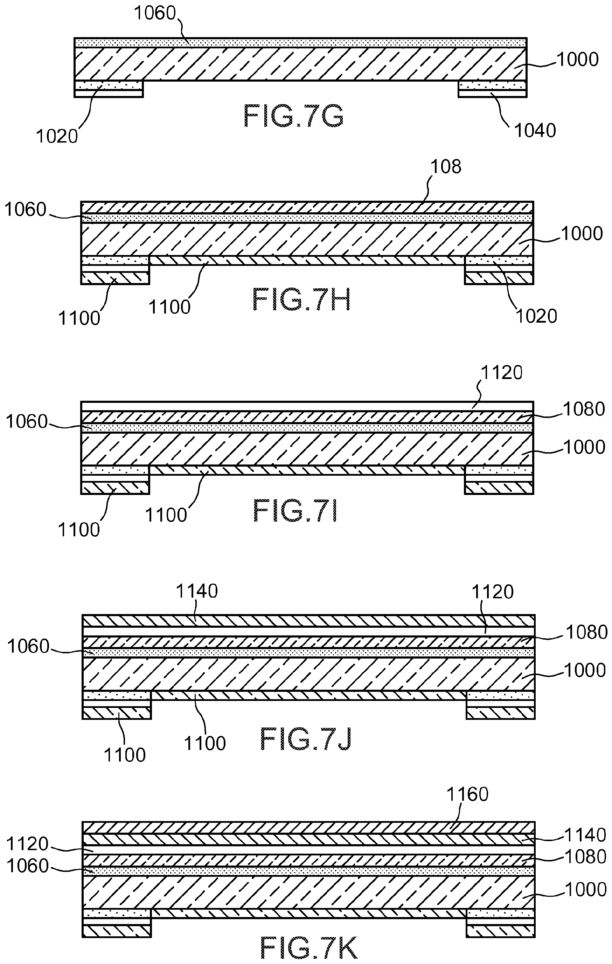

Lors d'une étape suivante, on forme une couche d'oxyde 1060 en face avant. Avantageusement, un recuit de densification a lieu par exemple à une température de l'ordre de 800°C. L'élément ainsi obtenu est représenté sur la figure 7G.

Lors d'une étape suivante, on forme une couche 1080 en face avant destinée à former la ou les poutres et une couche 1100 en face arrière. De préférence, ces couches sont par exemple en polysilicium, en SiC ou en SiO$_2$. L'épaisseur des couches 1080, 1100 est par exemple comprise entre quelques centaines de nm à plusieurs μm, voire plusieurs dizaines de μm.

Les couches 1080, 1100 sont par exemple réalisées par dépôt chimique en phase vapeur (ou CVD pour Chemical Vapor Deposition en terminologie anglosaxonne) ou par croissance épitaxiale. De préférence, les contraintes des couches 1080, 1100 sont maîtrisées.

Les couches 1080, 1100 peuvent être formées en plusieurs fois. Par exemple, pour une épaisseur de 4 μm, deux couches de 1,5 μm d'épaisseur et une couche de 1 μm d'épaisseur sont réalisées successivement.

Avantageusement une étape de recuit a ensuite lieu. L'élément ainsi obtenu est représenté sur la figure 7H.

Lors d'une étape suivante, une couche 1120 est formée sur la couche 1080 par exemple en SiO$_2$ ou en SiN, ayant par exemple une épaisseur comprise entre quelques centaines de nm et plusieurs μm. La couche 1120 est formée par exemple par oxydation thermique ou par dépôt CVD. Avantageusement, un recuit de densification a lieu par exemple à une température de l'ordre de 800°C.

L'élément ainsi obtenu est représenté sur la figure 7I.

Lors d'une étape suivante, on réalise les premier 14 et deuxième 18 actionneurs.

Pour cela on réalise tout d'abord une couche 1140 destinée à former les électrodes inférieures des actionneurs, par exemple en Pt ou en Mo. La couche 1140 est réalisée par exemple par dépôt sur la couche 1120. La couche 1140 a par exemple une épaisseur comprise entre quelques dizaines de nm à quelques centaines de nm. L'élément ainsi obtenu est représenté sur la figure 7J.

Une couche de matériau piézoélectrique ou ferroélectrique 1160 est ensuite formée sur la couche 1140, par exemple en PZT, AlN, ZnO, LNO dont l'épaisseur est par exemple comprise entre quelques centaines de nm à quelques μm.

On réalise ensuite l'électrode supérieure par formation d'une couche 1180 sur le matériau piézoélectrique ou ferroélectrique 1160, par exemple en Ru ou en Au par exemple d'épaisseur comprise entre quelques dizaines de nm à quelques centaines de nm. L'élément ainsi obtenu est représenté sur la figure 7K.

Ont lieu ensuite des étapes de gravure.

Tout d'abord, la couche 1180 est gravée de sorte à délimiter au moins une poutre 10 et les actionneurs 14 et 18.

Ensuite, la couche 1160 en matériau piézoélectrique ou ferroélectrique est gravée.

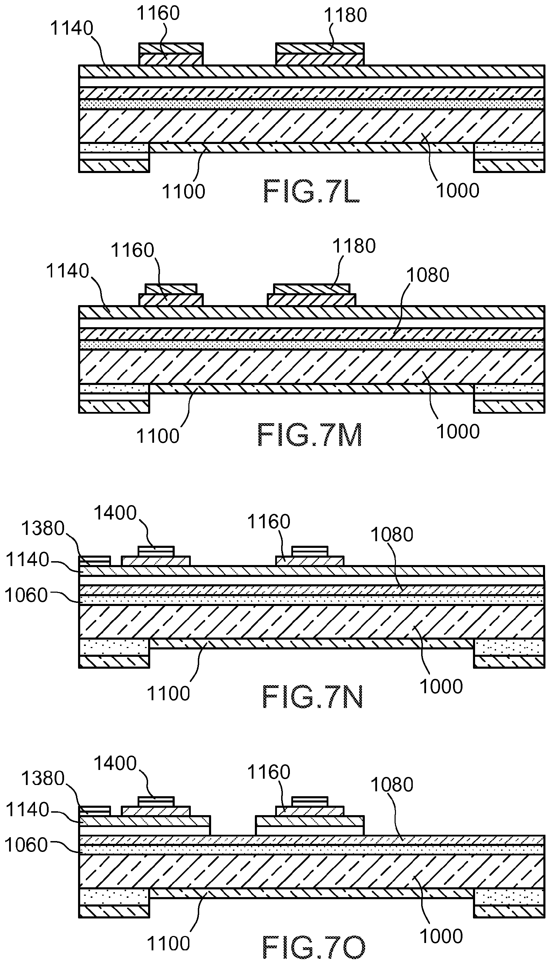

L'élément ainsi obtenu est représenté sur la figure 7L.

Ensuite, on grave à nouveau les portions de couche 1180 restantes de sorte à ce qu'elles soient en retrait par rapport aux portions de couche 1160. L'élément ainsi obtenu est représenté sur la figure 7M.

On forme une couche 1380 par exemple en Ruthénium et ensuite une couche 1400 par exemple en or. On réalise ensuite une gravure de sorte à définir des plots de contact ruthénium-or sur le matériau PZT et sur le bord de la couche 1140.

L'élément ainsi obtenu est représenté sur la figure 7N.

La couche 1140 est ensuite gravée, ainsi que la couche d'oxyde 1120.

De préférence, on réalise un profil en escalier. Celui-ci est obtenu car toutes les couches sont déposées puis gravées, à partir de la couche supérieure, en utilisant des masques de photolithographie différents, le deuxième masque étant plus large que le premier, etc. Cela permet de laisser des marges de sécurité pour éviter le recouvrement de couches, qui pourrait apparaître du fait de l'incertitude de positionnement des masques. On évite ainsi tout court-circuit électrique entre les électrodes. L'élément ainsi obtenu est représenté sur la figure 7O.

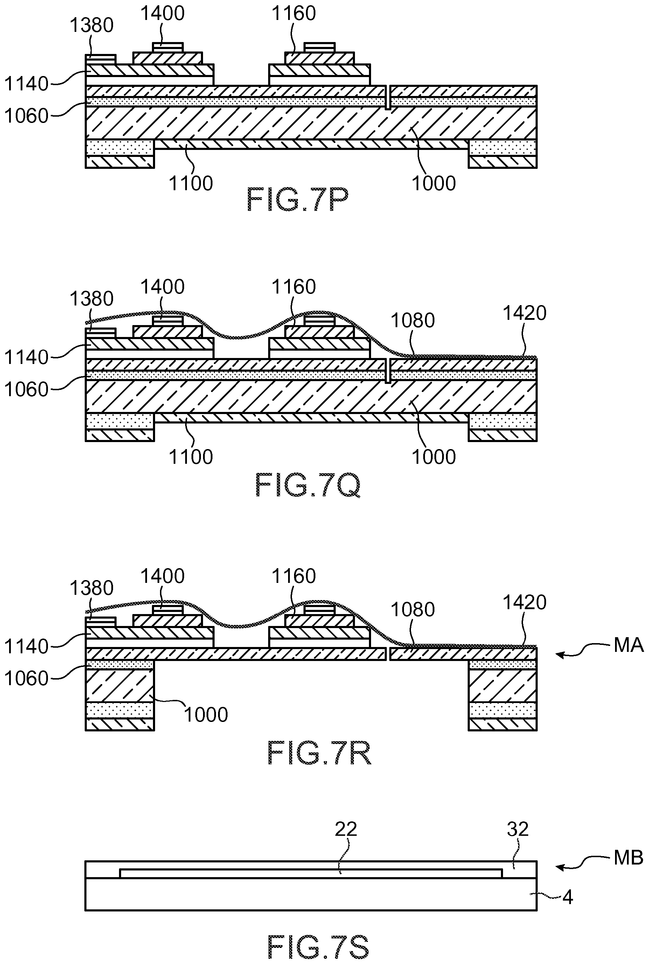

Lors d'une étape suivante, on grave les couches 1080, 1060 et sur une partie de son épaisseur la couche 1000 afin de définir les poutres. L'élément ainsi obtenu est représenté sur la figure 7P.

Lors d'une étape suivante, on dépose un film sec 1420 en face avant de l'élément de la figure 7P. Le film sec sert à protéger la face avant de l'élément lors de la gravure profonde qui va suive. Le film est ensuite avantageusement conservé pour former le support souple sur lequel les cellules vont adhérer. Ce support sera déformé par activation des actionneurs.

L'élément ainsi obtenu est représenté sur la figure 7Q.

Lors d'une étape suivante, on grave la face arrière afin de libérer les poutres par gravure profonde. On grave le substrat 1000 et la couche d'oxyde 1060 jusqu'à atteindre les poutres.

L'élément ainsi obtenu est représenté sur la figure 7R. Celui-ci forme le module d'actionnement MA.

Par ailleurs le module MB est fabriqué. La membrane est par exemple découpée dans un substrat souple en polymère, par exemple en PEN ou en PC, dont l'épaisseur peut être comprise entre quelques μm et plusieurs centaines de μm, voir quelques mm.

Lors d'une étape suivante, on réalise l'électrode 22 sur la membrane par exemple au moyen d'un masque de sérigraphie de sorte à réaliser un dépôt localisé de l'électrode 22.

Lors d'une étape suivante, une couche de passivation peut être avantageusement déposée sur l'électrode 22. La couche est par exemple en polymère. La couche de passivation peut par exemple être réalisée par centrifugation (spin coating en terminologie anglo-saxonne).

La membrane munie de l'électrode 22 et de la couche de passivation est représentée sur la figure 7S.

Lors d'une étape suivante, le module MB et le module d'actionnement MA sont assemblés.

Comme cela a été décrit en relation avec les figures 5 et 6, ils peuvent être assemblés par l'intermédiaire d'un boîtier d'un dispositif microfluidique ou d'un support d'un bouton haptique.

La distance entre la face supérieure du module d'actionnement et la face inférieure de la membrane est maîtrisée pour contrôler précisément la déformation de la membrane, et cette distance est de préférence minimisée, elle est par exemple au plus égale à 1 μm afin de maximiser l'effet du déplacement des poutres sur la déformation de la membrane. La distance est maîtrisée par assemblage du module NB et du module d'actionnement MA.

Le module d'actionnement est par exemple collé dans le boîtier et la membrane est collé sur le fond du boîtier par-dessus le module MA.

Il peut être envisagé que la face de la membrane soit en contact avec le module MA

Dans le cas d'un bouton haptique, le support peut être réalisé par injection ou impression 3D et Le module d'actionnement est par exemple collé dans le support et la membrane est collée sur le support par-dessus le module MA. Il peut être envisagé que la face de la membrane soit en contact avec le module MA

Le dispositif selon l'invention est particulièrement adapté au domaine de traitement des cellules biologiques. Il est également adapté à la réalisation d'interfaces haptiques, par exemple pour le domaine automobile.

**Revendications**

1. Dispositif à membrane comportant un support, une membrane (4) suspendue audit support (2) et au moins un module d'actionnement (MA) disposé en regard d'une face de la membrane (4) et distinct de ladite membrane (4), ledit module d'actionnement (MA) comportant au moins un premier actionneur (14) comprenant au moins un premier matériau (12) apte se dilater et/ou se contracter sous l'effet d'un stimulus extérieur solidaire d'un élément (10) ancré au support (2) et distinct de la membrane (4), de sorte que, lorsqu'un stimulus extérieur est appliqué au premier matériau (12), un effet bilame apparaît entre le premier matériau (12) et l'élément (10), déformant l'élément (10) en direction de la membrane (4) et provoquant la déformation de la membrane (4), **caractérisé en ce que** la membrane est au moins en partie en un matériau polymère et **en ce que** ledit dispositif comporte également au moins un actionneur électrostatique (8) configurée pour plaquer au moins une partie de la membrane (4) sur au moins une partie du module d'actionnement (MA).

2. Dispositif à membrane selon la revendication 1, dans lequel ledit élément (10) comporte une poutre encastrée-libre.

3. Dispositif a membrane selon la revendication 1 ou 2, comportant plusieurs éléments (10) ancrés au support (2).

4. Dispositif à membrane selon les revendications 2 et 3, dans lequel les poutres encastrées-libres (10) sont disposées radialement et dans lequel chaque poutre (10) comporte une extrémité libre, les extrémités libres des poutres étant situées au niveau d'une partie centrale de la membrane (4).

5. Dispositif à membrane selon l'une des revendications 1 à 4, dans lequel le module d'actionnement (MA) comporte en outre, au moins un deuxième actionneur (18) comprenant un deuxième matériau (16) apte se dilater et/ou se contracter sous l'effet d'un stimulus extérieur, ledit deuxième actionneur (18) étant solidaire dudit élément (10), ledit deuxième matériau (16) étant avantageusement disposé par rapport au premier matériau (12) de sorte à être apte à appliquer audit élément (10) une déformation de courbure opposée à celle appliquée par le premier matériau (12).

**6.** Dispositif à membrane selon l'une des revendications 1 à 5, dans lequel le au moins un actionneur électrostatique (8) comporte au moins une électrode (22) portée par la membrane (4) et au moins une électrode solidaire dudit élément (10).

**7.** Dispositif à membrane selon l'une des revendications précédentes, dans lequel le premier (12) et/ou le deuxième matériau (16) est un matériau piézoélectrique ou ferroélectrique, le premier (14) et/ou le deuxième (18) actionneur comportant des électrodes (15.1, 15.2, 20.1, 20.2) pour appliquer une différence de potentiel électrique aux premier (12) et/ou deuxième (16) matériau.

**8.** Dispositif à membrane selon la revendication 7, dans lequel le premier matériau (12) et/ou le deuxième matériau (16) sont choisis parmi l'AIN, le PZT, le ZNO, le LNO.

**9.** Dispositif à membrane selon l'une des revendications précédentes, dans lequel le premier actionneur (14) et/ou le deuxième actionneur (18) est ou sont des actionneurs thermiques.

**10.** Dispositif à membrane selon la revendication 7 ou 8 en combinaison avec la revendication 6, dans lequel la au moins une électrode solidaire de l'élément est au moins l'une des électrodes (15.1, 15.2, 20.1, 20.2) du premier (14) et/ou du deuxième (18) actionneur.

**11.** Dispositif à membrane selon l'une des revendications précédentes, comportant des moyens pour mettre en vibration la membrane, lesdits moyens pour mettre en vibration la membrane comprenant avantageusement le premier et/ou le deuxième actionneur.

**12.** Dispositif à membrane selon l'une des revendications 1 à 11, dans lequel le matériau polymère de la membrane (4) est un polymère transparent.

**13.** Dispositif de traitement de cellules biologique (S) comportant au moins un dispositif à membrane selon l'une des revendications 1 à 12.

**14.** Interface haptique comportant au moins un dispositif à membrane selon l'une des revendications 1 à 12.

**15.** Procédé de réalisation d'un dispositif à membrane selon l'une des revendications 1 à 12, comportant les étapes :

- réalisation d'un module d'actionnement (MA),
- réalisation d'une membrane (4) tout ou partie en matériau polymère,
- réalisation d'un actionneur électrostatique (8) configuré pour plaquer au moins une partie de la membrane (4) sur au moins une partie du module d'actionnement (MA),
- assemblage du module d'actionnement (MA) et de la membrane (4) de sorte que l'activation du module d'actionnement déforme la membrane (4).

**Patentansprüche**

**1.** Membranvorrichtung, umfassend einen Träger, eine Membran (4), die an dem Träger (2) hängt, und wenigstens ein Betätigungsmodul (MA), das gegenüber einer Seite der Membran (4) angeordnet ist und von der Membran (4) verschieden ist, wobei das Betätigungsmodul (MA) wenigstens ein erstes Betätigungselement (14) umfasst, das wenigstens ein erstes Material (12) umfasst,

**2.** Wirkung eines äußeren Reizes, der fest mit einem Element (10) verbunden ist, das an dem Träger (2) verankert ist und von der Membran (4) verschieden ist, sodass, wenn ein äußerer Reiz auf das erste Material (12) angewendet wird, ein Bimetalleffekt zwischen dem ersten Material (12) und dem Element (10) auftritt, wodurch das Element (10) in Richtung der Membran (4) verformt wird und die Verformung der Membran (4) bewirkt wird, **dadurch gekennzeichnet, dass** die Membran wenigstens teilweise aus einem Polymermaterial besteht und dadurch, dass die Vorrichtung ebenfalls wenigstens ein elektrostatisches Betätigungselement (8) umfasst, das ausgestaltet ist, wenigstens einen Teil der Membran (4) auf wenigstens einen Teil des Betätigungsmoduls (MA) zu drücken.
2. Membranvorrichtung nach Anspruch 1, wobei das Element (10) einen freien Einbaubalken umfasst.

**3.** Membranvorrichtung nach Anspruch 1 oder 2, umfassend mehrere Elemente (10), die an dem Träger (2) verankert sind.

**4.** Membranvorrichtung nach den Ansprüchen 2 und 3, wobei die freien Einbaubalken (10) radial angeordnet sind und wobei jeder Balken (10) ein freies Ende umfasst, wobei sich die freien Enden der Balken auf Höhe eines Mittelteils der Membran (4) befinden.

**5.** Membranvorrichtung nach einem der Ansprüche 1 bis 4, wobei das Betätigungsmodul (MA) weiter wenigstens ein zweites Betätigungselement (18) umfasst, das wenigstens ein zweites Material (16) umfasst, das imstande ist, sich zu dehnen und/oder sich zusammenzuziehen unter der Wirkung eines äußeren Reizes, wobei das zweite Betätigungselement (18) fest mit dem Element (10) verbunden ist, wobei das zweite Material (16) vorteilhafterweise in Bezug auf das erste Material (12) so angeordnet ist, dass es imstande ist, auf das Element (10) eine Krümmungsverformung anzuwenden, die jener entgegengesetzt ist, die von dem ersten Material (12) angewendet wird.

6. Membranvorrichtung nach einem der Ansprüche 1 bis 5, wobei das wenigstens eine elektrostatische Betätigungselement (8) wenigstens eine Elektrode (22), die von der Membran (4) getragen wird, und wenigstens eine Elektrode, die fest mit dem Element (10) verbunden ist, umfasst.

7. Membranvorrichtung nach einem der vorstehenden Ansprüche, wobei das erste (12) und/oder das zweite Material (16) ein piezoelektrisches oder ferroelektrisches Material ist, wobei das erste (14) und/oder das zweite (18) Betätigungselement Elektroden (15.1, 15.2, 20.1, 20.2) umfasst, um eine elektrische Potenzialdifferenz auf das erste (12) und/oder zweite (16) Material anzuwenden.

8. Membranvorrichtung nach Anspruch 7, wobei das erste Material (12) und/oder das zweite Material (16) ausgewählt werden aus AIN, PZT, ZNO, LNO.

9. Membranvorrichtung nach einem der vorstehenden Ansprüche, wobei das erste Betätigungselement (14) und/oder das zweite Betätigungselement (18) thermische Betätigungselemente sind.

10. Membranvorrichtung nach Anspruch 7 oder 8 in Kombination mit Anspruch 6, wobei die wenigstens eine Elektrode, die fest mit dem Element verbunden ist, wenigstens eine der Elektroden (15.1, 15.2, 20.1, 20.2) des ersten (14) und/oder des zweiten (18) Betätigungselements ist.

11. Membranvorrichtung nach einem der vorstehenden Ansprüche, umfassend Mittel, um die Membran in Schwingung zu versetzen, wobei die Mittel, um die Membran in Schwingung zu versetzen, vorteilhafterweise das erste und/oder das zweite Betätigungselement umfassen.

12. Membranvorrichtung nach einem der Ansprüche 1 bis 11, wobei das Polymermaterial der Membran (4) ein transparentes Polymer ist.

13. Vorrichtung zur Behandlung biologischer Zellen (S), umfassend wenigstens eine Membranvorrichtung nach einem der Ansprüche 1 bis 12.

14. Haptische Schnittstelle, umfassend wenigstens eine Membranvorrichtung nach einem der Ansprüche 1 bis 12.

15. Verfahren zur Ausführung einer Membranvorrichtung nach einem der Ansprüche 1 bis 12, umfassend folgende Schritte:

- Ausführen eines Betätigungsmoduls (MA),
- Ausführen einer Membran (4) zur Gänze oder zum Teil aus Polymermaterial,
- Ausführen eines elektrostatischen Betätigungselements (8), das ausgestaltet ist, wenigstens einen Teil der Membran (4) auf wenigstens einen Teil des Betätigungsmoduls (MA) zu drücken,
- Zusammenfügen des Betätigungsmoduls (MA) und der Membran (4), sodass die Aktivierung des Betätigungsmoduls die Membran (4) verformt.

**Claims**

1. Device with a membrane comprising a support, a membrane (4) suspended from said support (2) and at least one actuation module (MA) disposed facing a face of the membrane (4) and distinct from said membrane (4), said actuation module (MA) comprising at least one first actuator (14) comprising at least one first material (12) capable of expanding and/or contracting under the effect of an outside stimulus secured to an element (10) anchored to the support (2) and distinct from the membrane (4), in such a way that, when an outside stimulus is applied to the first material (12), a bimetallic-strip effect appears between the first material (12) and the element (10), deforming the element (10) in the direction of the membrane (4) and causing the deformation of the membrane (4), **characterised in that** said membrane (4) is at least partly made of a polymer material and **in that** said device also comprises at least one electrostatic actuator (8) configured to press at least a portion of the membrane (4) against at least a portion of the actuator module (MA).

2. Device with a membrane according to claim 1, wherein said element (10) comprises a cantilever beam.

3. Device with a membrane according to claim 1 or 2, comprising a plurality of elements (10) anchored to the support (2).

4. Device with a membrane according to claims 2 and 3, wherein the cantilever beams (10) are disposed radially and wherein each beam (10) comprises a free end, the free ends of the beams being located at a central portion of the membrane (4).

5. Device with a membrane according to one of claims 1 to 4, wherein the actuation module (MA) further comprises, at least a second actuator (18) comprising a second material (16) capable of expanding and/or contracting under the effect of an outside stimulus, said second actuator (18) being rigidly connected to said element (10), wherein said second material (16) is advantageously disposed with respect to the first material (12) in such a way as to be capable of applying, to said element (10), a deformation having a curvature opposite to that applied by the first material (12).

6. Device with a membrane according to one of claims 1 to 5, wherein the at least one electrostatic actuator (8) comprises at least one electrode (22) carried by the membrane (4) and at least one electrode rigidly connected to said element (10).

7. Device with a membrane according to one of the previous claims, wherein the first (12) and/or the second material (16) is a piezoelectric or ferroelectric material, the first (14) and/or the second (18) actuator comprising electrodes (15.1, 15.2, 20.1, 20.2) for applying a difference in electric potential to the first (12) and/or second (16) material.

8. Device with a membrane according to claim 7, wherein the first material (12) and/or the second material (16) are chosen from AIN, PZT, ZNO, LNO.

9. Device with a membrane according to one of the previous claims, wherein the first actuator (14) and/or the second actuator (18) is or are thermal actuators.

10. Device with a membrane according to claim 7 or 8 in combination with claim 6, wherein the at least one electrode secured to the element is at least one of the electrodes (15.1, 15.2, 20.1, 20.2) of the first (14) and/or of the second (18) actuator.

11. Device with a membrane according to one of the previous claims, comprising means for vibrating the membrane, wherein the means for vibrating the membrane advantageously comprise the first and/or the second actuator.

12. Device with a membrane according to one of claims 1 to 11, wherein the polymer material of the membrane (4) is a transparent polymer.

13. Device for treatment of biological cells (S) comprising at least one device with a membrane according to one of claims 1 to 12.

14. Haptic interface comprising at least one device with a membrane according to one of claims 1 to 12.

15. Method for creating a device with a membrane according to one of claims 1 to 12, comprising the steps:

- creation of an actuation module (MA),
- creation of a membrane (4) entirely or portion made of a polymer material,
- creation of an electrostatic actuator (8) configured to press at least a portion of the membrane (4) against at least a portion of the actuator module (MA)
- assembly of the actuation module (MA) and of the membrane (4) in such a way that the activation of the actuation module deforms the membrane (4).

14    18

2

10

10

14

# FIG.1

22   10.1   d   20.2   18   4

MB

8

MA

2

10   12   14   16   20.1   6

15.1   15.2

# FIG.2

FIG.3A

FIG.3B

FIG.4A

FIG.4B

FIG.5

FIG.6

FIG.7A

1020

1000

FIG.7B

1020

1000

1040

FIG.7C

1020

1000

1040

FIG.7D

1020

1000

1040

FIG.7E

1020

1000

1040

FIG.7F

1060

1000

## FIG.7G

1020          1040

108

1060

1000

## FIG.7H

1100     1100          1020

1120

1080

1060

1000

## FIG.7I

1100     1100

1140          1120

1080

1060

1000

## FIG.7J

1100     1100

1160

1140

1120          1080

1060

1000

## FIG.7K

1140    1160          1180

FIG.7L

1100          1000

1160          1180          1080

1140

FIG.7M

1100          1000

1380    1400          1160          1080

1140

1060

FIG.7N

1100          1000

1380    1400          1160          1080

1140

1060

FIG.7O

1100          1000

1380  1400  1160

1140

1060

1100  1000

**FIG.7P**

1380  1400  1160  1080  1420

1140

1060

1100  1000

**FIG.7Q**

1380  1400  1160  1080  1420

1140

1060

MA

1000

**FIG.7R**

22  32

MB

4

**FIG.7S**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2003262920 B

**Littérature non-brevet citée dans la description**

- **P. PONCET ; F. CASSET ; A. LATOUR ; F. DOMINGUES DOS SANTOS ; S. PAWLAK ; R. GWOZIECKI ; S. FANGET.** Design and realization of electroactive polymer actuators for transprent and flexible haptic feedback interfaces. *Int. Conf. on Thermal, mechanical and multi-physics simulation and experiments in microelectronics and microsystems (Eurosime),* 2016

- **CASSET et al.** Zipping variable capacitor development. *Mechatronics,* 2004